# EUROPÄISCHE PATENTSCHRIFT

(11) **EP 2 633 379 B1**
(45) Veröffentlichungstag und Bekanntmachung des Hinweises auf die Patenterteilung: **05.12.2018**
(21) Anmeldenummer: 11775757.5
(22) Anmeldetag: 20.10.2011
(51) Int. Cl.: G06F 1/20, H05K 7/20

(54) **REGELSCHALTUNG UND VERFAHREN ZUR DREHZAHLREGELUNG, DATENVERARBEITUNGSVORRICHTUNG UND PROGRAMMCODE**
CONTROL CIRCUIT AND METHOD FOR CONTROLLING ROTARY SPEED, DATA PROCESSING DEVICE, AND PROGRAM CODE
CIRCUIT DE RÉGLAGE ET PROCÉDÉ DE RÉGLAGE DE VITESSE DE ROTATION, DISPOSITIF DE TRAITEMENT DE DONNÉES ET CODES DE PROGRAMME

(30) Priorität: 27.10.2010 DE 102010049856
(43) Veröffentlichungstag der Anmeldung: 04.09.2013
(73) Patentinhaber: Fujitsu Technology Solutions Intellectual Property GmbH, 80807 München (DE)
(72) Erfinder: BUSCH, Peter, 86179 Augsburg (DE)
(74) Vertreter: Epping - Hermann - Fischer
(86) Internationale Anmeldenummer: PCT/EP2011/068373
(87) Internationale Veröffentlichungsnummer: WO 2012/055768

(56) Entgegenhaltungen:
- US-A1- 2004 234 376
- US-A1- 2008 013 929

## Beschreibung

Die Erfindung betrifft eine Regelschaltung zur Drehzahlregelung eines pulsweitenmodulierten Lüfters mit einem digitalen Steuerregister zum Einstellen eines Tastverhältnisses zur Ansteuerung des Lüfters. Darüber hinaus betrifft die Anmeldung eine Datenverarbeitungsvorrichtung umfassend eine derartige Regelschaltung sowie ein Verfahren und Programmcode zur Drehzahlregelung eines pulsweitenmodulierten Lüfters.

Regelschaltungen zur Drehzahlregelung pulsweitenmodulierter Lüfter sind aus dem Stand der Technik bekannt. Beispielsweise offenbart die Patentschrift DE 102004002447 B4 eine Regelschaltung mit Übertemperatursignalisierung. Dabei enthält die Lüfterregelschaltung einen Eingang zum Zuführen eines temperaturabhängigen Steuersignals zur Drehzahlsollwertung des Lüfters. Bei Erreichen einer ersten Temperaturschwelle wird durch Invertierung eines Signals an einem ersten Signalausgang, der die aktuelle Drehzahl des Lüfters anzeigt, eine Übertemperaturwarnung signalisiert. Diese und andere Regelschaltungen eignen sich insbesondere zur Regelung elektronisch kommutierter Lüfter, die wegen ihres Anschlussschemas oft auch als Vierdrahtlüfter bezeichnet werden.

Aus der Druckschrift US 2004/0234376 A1 ist ein System mit einem PWM-Generator und einer Steuerlogik bekannt. Der PWM-Generator ist dazu eingerichtet, ein PWM-Signal mit einem Ein-/Aus-Verhältnis zu generieren, das auf einem Ein-/Aus-Verhältniswert basiert, das von der Steuerlogik erzeugt und generiert wird. Die Steuerlogik ist hierbei so konfiguriert, dass der Ein-/Aus-Verhältniswert so generiert wird, dass er in einem teilweise linearen Verhältnis zur Temperatur steht, wobei wenigstens zwei einer Mehrzahl linearer Abschnitte, die durch das teilweise lineare Verhältnis definiert werden, unterschiedliche Steigungen aufweisen. In einigen Ausgestaltungen kann das teilweise lineare Verhältnis kontinuierlich sein.

Die US 6,874,327 B1 beschreibt ein System und ein Verfahren, die Auflösung einer Berechnung eines pulsweitenmodulierten Signals in einer Lüftersteuerung zum Steueren einer Umdrehungsgeschwindigkeit wenigstens eines Lüfters zu erhöhen. Das Verfahren kann hierbei das Erfassen eines Temperaturwerts eines ersten Temperatursensors während eines ersten Zeitintervalls umfassen. Der Temperaturwert hat eine Auflösung von einer ersten Anzahl von Bits. Ein Teil der ersten Anzahl von Bits wird zum Berechnen eines PWM signals ausgewählt, wobei lediglich der Teil der ersten Anzahl an Bits genutzt wird, der dem ersten Temperatursensor zuordenbar ist.

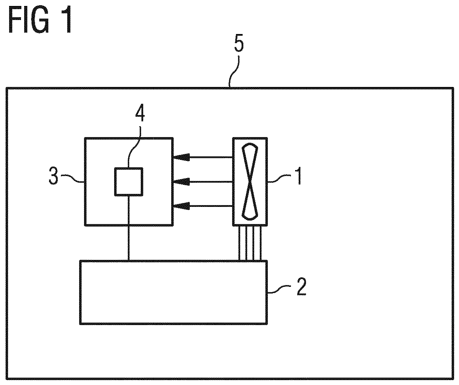

In der Figur 1 ist eine beispielhafte Anordnung umfassend einen pulsweitenmodulierten Lüfter 1, eine Regelschaltung 2 sowie eine zu kühlende Komponente 3 dargestellt. Im Bereich der Komponente 3 ist ein Temperatursensor 4 angeordnet, mit dessen Hilfe die Temperatur der zu kühlenden Komponente 3 erfasst werden kann, um einen Regelwert für die Regelschaltung 2 vorzugeben. In der in der Figur 1 dargestellten Anordnung sind die Komponenten 2, 3 und 4 auf einer gemeinsamen Leiterplatte 5 einer Datenverarbeitungsvorrichtung wie beispielsweise einem Computersystem oder einer Netzwerkkomponente angeordnet.

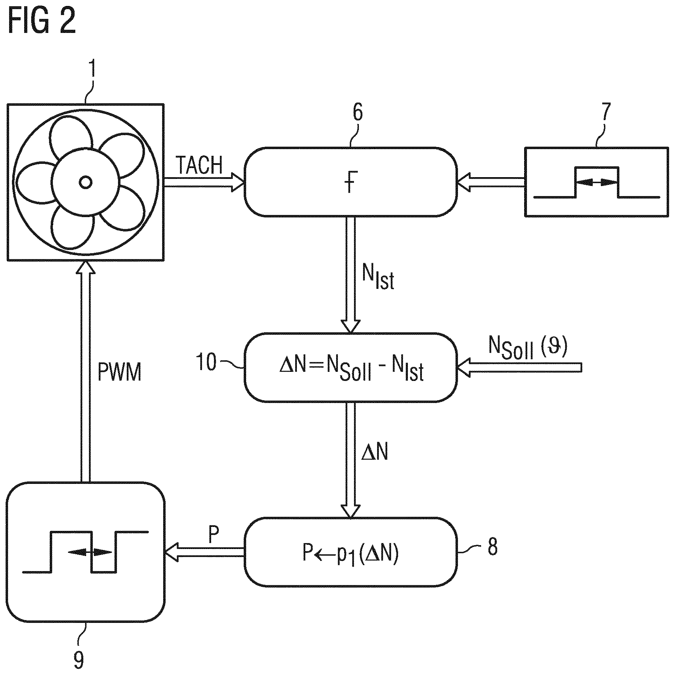

Im Folgenden wird anhand der Figur 2 eine konventionelle Regelung des Lüfters 1 beschrieben. Der pulsweitenmodulierte Lüfter 1 erzeugt ein Tachosignal TACH, wobei das Tachosignal beispielsweise ein oder zwei Tachoimpulse pro Umdrehung des Lüfterrades enthält. Dieses Tachosignal wird einer Frequenzmessvorrichtung 6 zugeführt. Die Frequenzmessvorrichtung 6 erhält des Weiteren ein Steuersignal von einer Zeitgebervorrichtung 7. Die Zeitgebervorrichtung 7 umfasst beispielsweise einen digitalen Oszillator sowie eine Steuerlogik zur Bestimmung einer Fensterlänge zur Messung einer Frequenz durch die Frequenzmessvorrichtung 6.

Die Frequenzmessvorrichtung 6 bestimmt die Anzahl der Tachoimpulse des Tachosignals TACH, die in einem durch die Zeitgebervorrichtung 7 bestimmten Zeitfenster erfasst werden. Beispielsweise kann durch die Frequenzmessvorrichtung 6 bestimmt werden, wie viel Tachoimpulse innerhalb einer Sekunde auftreten. Dieser Wert N_{Ist} wird dann durch einen Drehzahlvergleicher 10 mit einem vorgegeben Sollwert N_{Soll}, der beispielsweise in Abhängigkeit einer gemessenen Temperatur ϑ bestimmt wird, verglichen.

Die Differenz zwischen der Sollzahl der Tachoimpulse N_{Soll} und der Istzahl der Tachoimpulse N_{Ist} wird als Wert ΔN an eine Pulsweitensteuervorrichtung 8 übertragen. Anhand des Differenzwertes ΔN wird daraufhin mittels einer Funktion p₁ (ΔN) ein Tastverhältnis als Digitalwert P zur Ansteuerung des Lüfters 1 für eine Pulsweitenmodulationsvorrichtung 9 vorgegeben. Die Funktion p₁ kann beispielsweise in Form einer Tabelle mit Steuerwerten P für bestimmte Differenzwerte ΔN vorgegeben werden. Abhängig von dem Wert P wird dann ein freilaufender Zähler der Pulsweitenmodulationsvorrichtung 9 auf das gewünschte Tastverhältnis nachgeregelt. Die Pulsweitenmodulationsvorrichtung 9 erzeugt daraus ein pulsweitenmodulierte Signal PWM und stellt es dem Lüfter 1 über eine Ansteuerleitung zur Verfügung.

Durch die Erfassung von Tachoimpulsen innerhalb eines begrenzten Messzeitfensters von zum Beispiel einer Sekunde reduziert sich die Genauigkeit der Drehzahlerfassung. Bei einer Drehzahl von beispielsweise 800 Umdrehungen pro Minute und zwei Tachoimpulsen pro Umdrehung ergibt sich nach einer Sekunde beispielsweise ein Zählerstand von 26, während der mathematisch korrekte Wert bei 26,67 liegt. Im zuvor beschriebenen Fall tritt also bereits bei der Drehzahlerfassung ein Fehler von etwa 2,5 % auf.

Eine Verbesserung der Messung könnte beispielsweise durch Verlängerung des Zeitfensters bewirkt werden, wobei dann jedoch die Regelgeschwindigkeit der Regelschaltung 2 abnehmen würde. Des Weiteren müssten zusätzlich bestimmte Regelparameter eingehalten werden, um ein Aufschaukeln der Lüfterdrehzahl zu verhindern.

Wie oben beschrieben wird abhängig der ermittelten Anzahl N_{Ist} von bestimmten Tachoimpulsen dann ein freilaufender Zähler der Pulsweitenmodulationsvorrichtung 9 auf das gewünschte Tastverhältnis eingestellt. Preisgünstige Zähler dieser Art haben eine Auflösung von acht Bit, so dass theoretisch eine Auflösung von 0 - 100 % des Tastverhältnisses in 255 Schritten möglich wäre. Da jedoch eine sinnvoll nutzbare Frequenz des PWM-Ansteuersignals für den Lüfter 1 oft in engen Grenzen vorgegeben ist, beispielsweise 20 - 25 kHz, ein Oszillatortakt des Zählers in der Regel aber nur in Zweier und/oder Viererschritten herunter geteilt werden kann, muss man den obersten möglichen Steuerwert der Pulsweitensteuervorrichtung 8 auf einen niedrigeren Wert als 255 begrenzen, um die korrekte Ansteuerfrequenz zu erhalten. Geschieht dies beispielsweise auf einen Wert von 100, so hat ein Lüfter 1 mit einer maximalen Drehzahl von 5000 Umdrehungen pro Minute bereits nur noch eine Ansteuerauflösung von 50 Umdrehungen pro Minute je nutzbarem Bit des Steuerregisters. Die Erhöhung beziehungsweise Erniedrigung einer Drehzahl von 50 Umdrehungen pro Minute ist bereits deutlich hörbar. Solche hörbaren Änderungen des Betriebsgeräusches des Lüfters 1 werden von einem Nutzer einer Datenverarbeitungsvorrichtung oftmals als störend empfunden.

Eine Verbesserung der Ansteuerung könnte beispielsweise durch eine höherwertige Pulsweitenmodulationsvorrichtung 9 mit einem höher aufgelösten Zähler bewirkt werden. Dies hat jedoch Kostennachteile zur Folge, da die in integrierten Regelschaltungen vorhandenen Zähler dann nicht mehr eingesetzt werden können.

Aufgabe der vorliegenden Erfindung ist es, eine verbesserte Regelschaltung beziehungsweise ein Verfahren zur Drehzahlregelung eines pulsweitenmodulierten Lüfters zu beschreiben, das die Regelgenauigkeit verbessert. Dabei soll das Verfahren möglichst einfach in Hardware oder in Software zu implementieren sein.

Die Aufgabe wird durch eine Regelschaltung zur Drehzahlregelung eines pulsweitenmodulierten Lüfters gelöst, der eine Messvorrichtung zur Ermittlung einer Periodendauer eines Tachosignals des Lüfters umfasst. Die Regelschaltung umfasst des Weiteren ein digitales Regelregister zum Erfassen eines Regelwerts zur Ansteuerung des Lüfters in Abhängigkeit einer ermittelten Periodendauer und eines Sollwertes sowie ein digitales Steuerregister zum Einstellen eines Tastverhältnisses zur Ansteuerung des Lüfters. Dabei weist das digitale Steuerregister eine geringere Registerbreite auf als das digitale Regelregister. Die Regelschaltung umfasst des Weiteren Steuermittel, die dazu eingerichtet sind, das digitale Steuerregister durch Auswertung einer vorbestimmten Anzahl höherwertiger Bits des digitalen Regelregisters zu aktualisieren. Die Regelschaltung ist dadurch gekennzeichnet, dass die Messvorrichtung einen Digitalzähler umfasst, dessen Zählerstand mit jedem Taktsignal eines Oszillators um einen vorbestimmten Wert verändert wird, wobei die Periodendauer auf Grundlage einer Differenz zwischen einem ersten Zählerstand beim Empfang eines ersten Tachoimpulses und einem zweiten Zählerstand beim Empfang eines zweiten Tachoimpulses ermittelt wird.

Durch das Zusammenwirken einer Messvorrichtung zur Ermittlung einer Periodendauer eines Tachosignals in Verbindung mit einem digitalen Regelregister zum Erfassen eines Regelwertes kann die Steuergenauigkeit der Regelschaltung mit geringem Aufwand verbessert werden. Insbesondere erlaubt die beschriebene Regelschaltung eine sehr genaue Erfassung des Tachosignals für einzelne Periodendauern einer Lüfterumdrehung. Ausgehend von diesem genauen Wert kann dann das digitale Regelregister aktualisiert werden, wobei das Regelregister gleichzeitig als Speicher für Tastverhältniswerte und als Regler dient. Dadurch dass nachfolgend durch die Steuermittel nur eine vorbestimmte Anzahl höherwertiger Bits zur Aktualisierung des eigentlichen Steuerregisters verwendet werden, wird effektiv die Regelgenauigkeit der Regelschaltung erhöht, ohne dass es hierzu einer aufwändigeren Pulsweitensteuervorrichtung bedarf. Eine derartige Messvorrichtung ist besonders einfach zu implementieren. Beispielsweise kann ein ohnehin vorhandener Oszillator verwendet werden, um mit Hilfe eines einfachen Zählers die Periodendauer des Tachosignals sehr genau zu bestimmen.

Gemäß einer vorteilhaften Ausgestaltung ist die Regelschaltung dadurch gekennzeichnet, dass das digitale Steuerregister eine Registerbreite von m Bit aufweist und das digitale Regelregister eine Registerbreite von n Bit aufweist. Dabei sind die Steuermittel dazu eingerichtet, das digitale Steuerregister durch eine bitweise Verschiebung des Inhalts des Regelregister um (n - m) Bit zu aktualisieren. Eine bitweise Verschiebung des Inhalts des Regelregisters zur Aktualisierung des Steuerregisters ermöglicht eine besonders einfache und effektive Aktualisierung des Steuerregisters.

Gemäß einer vorteilhaften Ausgestaltung ist die Regelschaltung dadurch gekennzeichnet, dass ein Überlaufregister zum Speichern einer Anzahl von Überläufen des Digitalzählers zwischen dem ersten und dem zweiten Tachoimpuls vorgesehen ist. Dabei ist die Messvorrichtung des Weiteren dazu eingerichtet, bei der Bestimmung der Periodendauer die in dem Überlaufregister gespeicherte Anzahl der Überläufe zu berücksichtigen. Durch die Berücksichtigung von Überläufen können auch verhältnismäßig einfache Zähler mit einer geringen Registerbreite eingesetzt werden, um verhältnismäßig lange Periodendauern zu erfassen.

Gemäß einer weiteren vorteilhaften Ausgestaltung ist die Regelschaltung durch Überwachungsmittel zum Überwachen des Überlaufregisters gekennzeichnet, wobei die Messvorrichtung dazu eingerichtet ist, beim Erreichen einer vorbestimmten Anzahl von Überläufen eine Periodendauer unabhängig vom Empfang des zweiten Tachoimpulses zu ermitteln und zur Verarbeitung durch das digitale Regelregister auszugeben. Durch derartige Überwachungsmittel kann die Funktion der Regelschaltung auch bei einem vollständigen Blockieren des Lüfters aufrechterhalten werden. Insbesondere wird das Regelregister wenigstens einmal je Erreichen der vorbestimmten Anzahl von Überläufen aktualisiert.

Gemäß einer weiteren vorteilhaften Ausgestaltung ist die Regelschaltung durch Subtrahiermittel zum Bestimmen einer Differenz zwischen einem von der Messvorrichtung bereitgestellten digitalen Istwert, der der bestimmten Periodendauer des Tachosignals entspricht, und dem Sollwert gekennzeichnet, wobei die Steuermittel dazu eingerichtet sind, einen Inhalt des Regelregisters vorzeichenrichtig um die durch das Subtrahiermittel bestimmte Differenz zu korrigieren. Durch die Vorsehung eines Vergleichmittels und die vorzeichengerechte Aktualisierung des Regelregisters kann eine einfache Nachführung des Inhalts des Regelregisters bewirkt werden.

Die beschriebene Regelschaltung eignet sich beispielsweise zur Verwendung in einer Datenverarbeitungsvorrichtung umfassend wenigstens eine zu kühlende Komponente und wenigstens einen pulsweitenmodulierten Lüfter zum Kühlen der zu kühlenden Komponente mit wenigstens einem ersten Anschluss zum Bereitstellen eines pulsweitenmodulierten Steuersignals zur Steuerung der Lüfterdrehzahl und wenigstens einem zweiten Anschluss zum Erfassen eines Tachosignals.

Gemäß einer bevorzugten Ausgestaltung umfasst die Datenverarbeitungsvorrichtung des Weiteren wenigstens einen Temperatursensor und ein Auswertemittel, wobei das Auswertemittel dazu eingerichtet ist, in Abhängigkeit einer durch den Temperatursensor erfassten Temperatur einen Sollwert für die Regelschaltung bereitzustellen.

Die oben genannte Aufgabe wird schließlich durch ein Verfahren zur Drehzahlregelung eines pulsweitenmodulierten Lüfters mit den folgenden Schritten gelöst:
- Ermitteln einer Periodendauer eines Tachosignals des Lüfters,
- Aktualisieren eines Regelwerts zur Ansteuerung des Lüfters in Abhängigkeit der ermittelten Periodendauer und eines Sollwerts, wobei der Regelwert einen höherwertigen Anteil und einen niederwertigen Anteil umfasst und bei der Aktualisierung zumindest der niederwertige Anteil aktualisiert wird, und
- Bestimmen eines Tastverhältnisses zur Ansteuerung des Lüfters in Abhängigkeit des höherwertigen Anteils des bestimmten Regelwerts,
wobei die Schritte des Ermittelns der Periodendauer, der Aktualisierung des Regelwerts und der Bestimmung des Tastverhältnisses mindestens einmal je Umdrehung eines Lüfterrads des Lüfters und/oder einmal je Tachoimpuls des Tachosignals durchgeführt werden.

Durch die Aktualisierung eines Regelwerts in Abhängigkeit einer ermittelten Periodendauer kann ein verhältnismäßig genauer Regelwert für jede einzelne bestimmte Periodendauer des Tachosignals bestimmt werden. In Abhängigkeit davon kann auf Grundlage des höherwertigen Anteils des Regelwertes ein Tastverhältnis zur Ansteuerung des Lüfters mit einer geringeren Genauigkeit bestimmt werden. Durch die häufige Durchführung der Schritte des Ermittelns der Periodendauer, der Aktualisierung des Regelwerts und der Bestimmung des Tastverhältnisses kann die Regelgeschwindigkeit des Verfahrens bei gleichzeitiger Erhöhung der Regelgenauigkeit erhöht werden.

Das beschriebene Verfahren eignet sich beispielsweise zur Implementierung mittels Programmcode mit Prozessoranweisungen für einen Mikrocontroller, wobei beim Ausführen der Prozessoranweisungen durch den Mikrocontroller die oben genannten Schritte durchgeführt werden.

Weitere vorteilhafte Ausgestaltungen der Erfindung sind in den Unteransprüchen sowie der nachfolgenden ausführlichen Beschreibung von Ausführungsbeispielen angegeben.

Die Erfindung wird nachfolgend anhand unterschiedlicher Ausführungsbeispiele unter Bezugnahme auf die Figuren näher erläutert.

In den Figuren zeigen:
- Figur 1: eine Datenverarbeitungsvorrichtung mit einer Regelschaltung,
- Figur 2: eine schematische Darstellung eines konventionellen Regelverfahrens,
- Figur 3: eine schematische Darstellung eines Regelverfahrens gemäß einem Ausführungsbeispiel der Erfindung und
- Figur 4: eine schematische Darstellung einer Regelschaltung gemäß einem Ausführungsbeispiel der Erfindung.

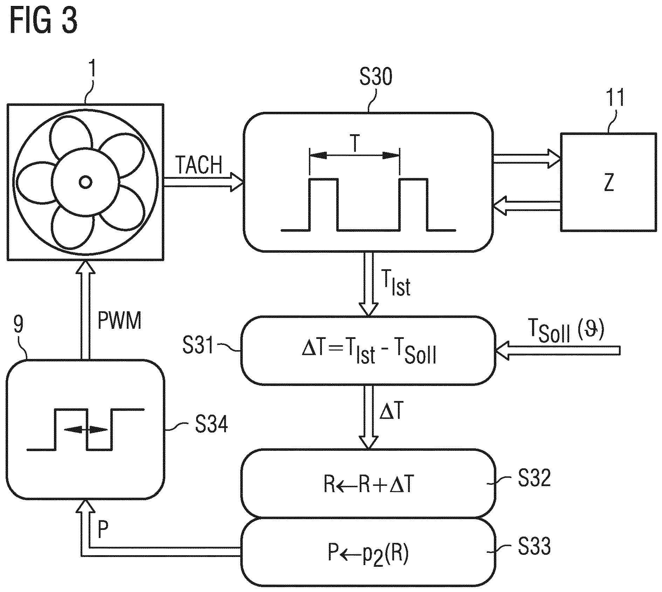

Figur 3 zeigt eine schematische Darstellung eines Verfahrens zur Drehzahlregelung eines pulsweitenmodulierten Lüfters 1.

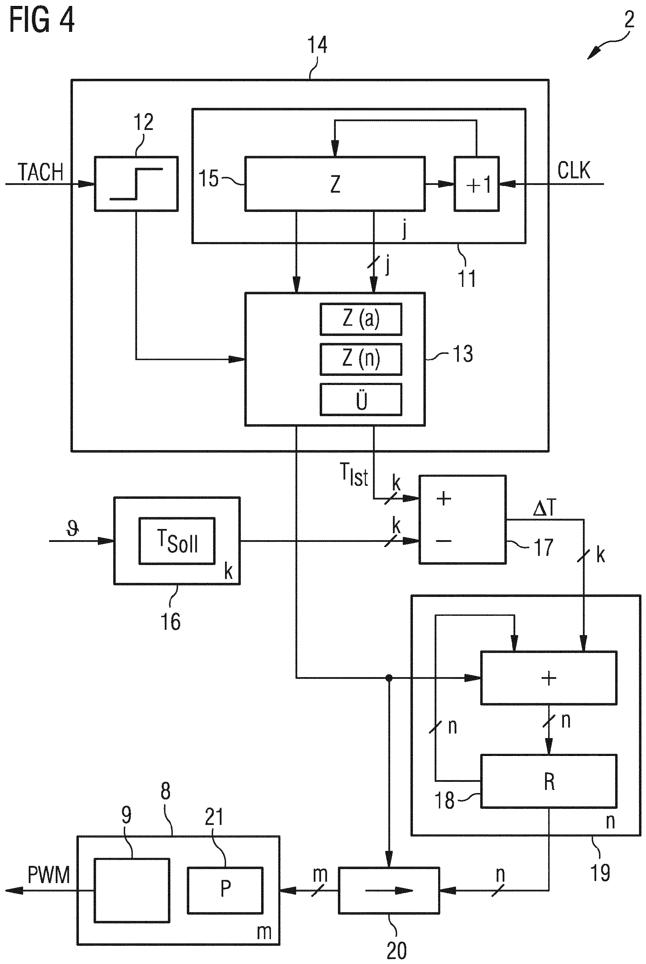

In einem ersten Schritt S30 wird die Periodendauer T_{Ist} eines Tachosignals TACH des Lüfters 1 bestimmt. Hierzu können beispielsweise ansteigende und abfallende Flanken von Tachoimpulsen des Lüfters 1 bestimmt werden. Selbstverständlich ist es auch möglich, die Differenz aufeinander folgender auf- oder absteigender Flanken des Tachosignals TACH zu bestimmen. Zur Bestimmung der Periodendauer T_{Ist} im Schritt S30 wird gemäß einem Ausführungsbeispiel ein digitaler Zähler 11 verwendet. Die genaue Ansteuerung des digitalen Zählers 11 wird später unter Bezugnahme auf die Regelschaltung 2 gemäß Figur 4 im Einzelnen erläutert.

Die im Schritt S30 bestimmte Periodendauer T_{Ist} wird in einem Schritt S31 mit einem vorgegebenen Sollwert T_{Soll} verglichen. Insbesondere wird die Differenz ΔT zwischen der gemessenen Periodendauer T_{Ist} und einem temperaturabhängigen Sollwert T_{Soll} bestimmt.

Die sich ergebende Differenz ΔT wird in einem nachfolgenden Schritt S32 vorzeichenrichtig auf den Wert R eines Regelregisters aufaddiert. Dadurch wird für jede bestimmte Periodendauer T_{Ist} der Inhalt R des Regelregisters korrigiert.

In einem nachfolgenden Schritt S33 wird auf Grundlage des Inhalts R des Regelregisters mittels einer Funktion p₂ (R) ein Steuerwert P für ein Steuerregister einer Pulsweitensteuervorrichtung 8 bestimmt. Im Ausführungsbeispiel wird der Steuerwert P durch Verschiebung des Inhalts R des Regelregisters um eine vorbestimmte Anzahl von Bitpositionen nach rechts bestimmt. Selbstverständlich können auch andere Funktionen, wie beispielsweise eine ganzzahlige Division der Regelwertes R ohne Bestimmung des Rests eingesetzt werden. Gegenüber bekannten Funktion p₁ zur Frequenzregelung sind diese deutlich einfacher als Schaltung bzw. als Mikrocontrollerprogramm zu implementieren.

In einem Schritt S34 wird daraufhin ein pulsweitenmoduliertes Steuersignal PWM auf Grundlage des Steuerwertes P durch eine Pulsweitenmodulationsvorrichtung 9 erzeugt. Dieses Signal dient direkt zur Ansteuerung des pulsweitenmodulierten Lüfters 1, so dass ein geschlossener Regelkreis entsteht.

Das beschriebene Verfahren eignet sich gleichermaßen zur Implementierung durch Programmcode eines Mikrocontrollers als auch zur Implementierung in Hardware. Eine beispielhafte Hardware-Regelschaltung 2 wird nachfolgend unter Bezugnahme auf die Figur 4 beschrieben.

Im dort dargestellten Ausführungsbeispiel wird das Tachosignal TACH eines Vierdrahtlüfters 1 einer Messvorrichtung 14 zugeführt. Die Messvorrichtung 14 umfasst einen Flankendetektor 12, dem das Tachosignal TACH zugeführt wird. Der Flankendetektor 12 erzeugt bei jeder steigenden Flanke des Tachosignals TACH einen Steuerimpuls und gibt diesen an ein Steuerwerk 13 einer Messvorrichtung 14 weiter. Die Messvorrichtung 14 umfasst des Weiteren einen Digitalzähler 11 mit einem j Bit breiten Zählerregister 15. Das Zählerregister 15 wird bei jeder ansteigenden Flanke eines externen Taktsignals CLK um den Wert 1 erhöht.

Das Steuerwerk 13 ist dazu eingerichtet, beim Empfangen eines ersten Steuersignals von dem Flankendetektor 12 den aktuellen Wert des Zählerregisters 15 in einem Zwischenspeicher Z(a) zu speichern. Bei einem nachfolgenden Steuersignal von dem Flankendetektor 12, also beim nächsten Tachoimpuls des Tachosignals TACH, wird der dann aktuelle Zählerstand Z des Zählerregisters 15 in einer weiteren Variable *Z(n)* erfasst. Zu diesem Zeitpunkt wird die Differenz zwischen neuem Zählerstand *Z(n)* und dem alten Zählerstand *Z(a)* bestimmt. Nachfolgend wird der Wert des neuen Zählerstandes *Z(n)* in die Speicherposition für den alten Zählerstand *Z(a)* übertragen.

Um eine genaue Erfassung der Periodendauer auch beim Überlaufen des Zählerregisters 15 zu ermöglichen, wird in einer weiteren Variable *Ü* die Anzahl der Überläufe des Zählerregisters 15 erfasst. Hierzu wird bei jedem Überlauf von dem Digitalzähler 11 ein weiteres Steuersignal an das Steuerwerk 13 übertragen. Daraufhin beginnt der Digitalzähler 11 erneut mit einem Zählerstand *Z* von 0 in dem Zählerregister 15. Die um den Überlauf korrigierte Berechnung im Fall eines freilaufenden Zählers 11 erfolgt im Ausführungsbeispiel dadurch, dass bei jeder neu erkannten Tachoimpulsflanke die Variable Ü durch achtmal Linksverschieben in eine 16-Bit-Variable Ü₁₆ verwandelt wird, und dann der Ausgabewert der Messvorrichtung 14 durch die Berechnung von *T_{Ist} = Ü₁₆* + *Z (n)* - *Z (a)* ermittelt und abgespeichert wird. Nach der Berechnung des Ausgabewertes *T_{Ist}* wird die Variable *Ü* auf 0 zurückgesetzt.

In einer vorteilhaften Ausgestaltung wird durch die Überwachung der Anzahl der Überläufe auch die Funktion des Lüfters überwacht. Wird bis zu einem vorher definierten Maximalwert der Variable *Ü*, beispielsweise vier Überläufen, kein neuer Tachoimpuls durch den Flankendetektor 12 erkannt, ist der Lüfter 1 entweder blockiert oder läuft viel zu langsam, um eine Kühlung aufrecht zu erhalten. In diesem Fall wird beim Erreichen des vorbestimmten Überlaufwerts der Wert *T_{Ist}* wie oben beschrieben ermittelt, um diesen Wert möglichst bald für eine Weiterverarbeitung durch die nachfolgende Schaltung zur Verfügung zu stellen. Danach wird der Zählerstand Z des frei laufenden Zählers trotz fehlendem Tachoimpuls ausgelesen und als Variable *Z(a)* gespeichert sowie die Variable *Ü* auf 0 zurückgesetzt. Danach wird auf den nächsten Tachoimpuls gewartet und sämtliche variablen Werte wie oben beschrieben zurückgesetzt, um die Messung auf den darauffolgenden übernächsten Tachoimpuls vorzubereiten wie oben beschrieben.

Der Vorteil der oben beschriebenen Art der Periodendauerermittlung *T_{Ist}* liegt nicht nur darin, dass dafür ein ohnehin vorhandener Digitalzähler 11, beispielsweise eines Mikrocontrollers, verwendet werden kann, sondern auch, dass durch diese Art der Periodendauerermittlung keine "halben Bits", also unvollständige Zählintervalle des Taktsignals CLK zwischen benachbarten Tachoimpulsen, verloren gehen. Denn der Rest des Taktintervalls trägt zum Ergebnis zur nächsten Messung der Periodendauer des Tachosignals TACH bei.

Alternativ, insbesondere wenn ein Mikrocontroller mit einem Interrupt gesteuerten, freien Zähler zur Verfügung steht, kann die Periodendauer T_{Ist} auch wie folgt bestimmt werden. Bei einem ersten Tachoimpuls wird beispielsweise mit Hilfe eines Interrupts ein Zählerstand *Z* eines Zählregisters 15 auf 0 zurückgesetzt und gestartet. Bei jedem neuen Tachoimpuls wird dann beispielsweise mit Hilfe eines weiteren Interrupts der dann aktuelle Zählerstand *Z* des Digitalzählers 11 ausgelesen und als Variable T_{Ist} beispielsweise in einem Acht-Bit-Register gespeichert. Sofort danach wird der Digitalzähler 11 wieder auf 0 zurückgesetzt und erneut gestartet.

Wenn ein derartiger Digitalzähler 11 überläuft und daraufhin wieder mit 0 beginnt, bevor ein neuer Tachoimpuls durch den Flankendetektor 12 erkannt wird, gibt es zwei mögliche Vorgehensweisen. Entweder muss durch Hochzählen einer Variable *Ü* wie oben beschrieben die Anzahl der Überlaufe für die Periodenmessung mitgezählt werden und dann bei der Ausgabe der Periodendauer T_{Ist} berücksichtigt werden. Auch in diesem Fall sollte ein Maximalwert für die Variable *Ü* festgelegt werden. Nach Erreichen des Maximalwerts sollte die Ausgabe einer vorbestimmten maximalen Periodendauer T_{Ist}, ein Rücksetzen des Digitalzählers 11 und ein erneuter Start des Digitalzählers 11 vorgenommen werden.

Trifft vor erneutem Überlauf des Digitalzählers 11 ein verspäteter Tachoimpuls ein, wird optional nicht ein dann falscher Wert T_{Ist} für die Lüfterperiode ausgegeben, sondern der Zähler erneut mit einem Wert von 0 gestartet, damit sichergestellt ist, dass immer ein Ausgangswert für die Periodendauer T_{Ist} erzeugt wird, entweder ein korrekter Wert oder, bei blockiertem Lüfter, ein zeitbegrenzter Wert. Dazu kann in einem weiteren Register ein Steuerbit gesetzt werden, dass das Erreichen des Maximalwerts kennzeichnet und gleichzeitig als Alarmsignal ausgewertet werden kann. Ist der Maximalwert hingegen gegenüber einer normalen Periodendauer eines funktionstüchtigen Lüfters 1 sehr groß gewählt, kann alternativ auch eine fehlerhaft zu kurz bestimmte Periodendauer weitergegeben werden, die gegenüber der durch den Maximalwert verursachten, sehr großen Korrektur nur einen geringen Einfluss auf die Lüfterregelung hat.

Alternativ kann auch das Überlaufsignal des Digitalzählers 11 als Begrenzung der maximal erfassten Tachoperiode verwendet werden. In diesem Fall wird der Maximalwert des Digitalzählers 11 als maximale Periodendauer T_{Ist} ausgegeben, wenn der Digitalzähler 11 auf 0 zurückgesetzt und gleich erneut gestartet wird. Auch in diesem Fall kann dann bei Eintreten eines verspäteten Tachoimpulses nicht der Inhalt des Zählerregisters 15 ausgegeben, sondern der Digitalzähler 11 nur durch ein geeignetes Resetsignal zurück auf 0 gesetzt und gestartet werden.

Zur Ermittlung der Regelabweichung der bestimmten Periodendauer T_{Ist} wird eine Sollwert T_{Soll} in einem Sollwertregister vorgegeben. Der Wert T_{Soll} kann entweder fest vorgegeben sein oder variabel durch eine Temperaturmessung oder andere Führungsgröße vorgegeben werden. Dieser Wert wird sich im normalen Betrieb der Regelschaltung 2 im Vergleich zur Lüfterperiode T_{Ist} gegenüber der Lüfterfrequenz nur langsam ändern. Gibt es mehrere Führungsgrößen, wie beispielsweise eine Temperaturmessung und eine externe Verstellung der beabsichtigten Lüfterdrehzahl, sollten diese Werte bereits in dem gemeinsamen Wert T_{Soll} der Temperatursteuerung 16 berücksichtigt werden.

Im in der Figur 4 dargestellten Ausführungsbeispiel wird der Sollwert T_{Soll} als digitaler Sollwert durch eine Temperaturregelung 16 vorgegeben, die nicht im Detail dargestellt ist. Beispielsweise kann in der Temperaturregelung 16 eine Lüfterkennlinie für verschiedene Temperaturen ϑ einer Datenverarbeitungsvorrichtung hinterlegt sein.

Der vorgegebene digitale Sollwert T_{Soll} wird durch einen Subtrahierer 17 von dem von der Messvorrichtung 14 bestimmten Istwert T_{Ist} der Periodendauer des Tachosignals TACH abgezogen. Im Ausführungsbeispiel handelt es sich um einen digitalen Subtrahierer 17, der zwei digitale Werte mit einer vorbestimmten Präzision, im Ausführungsbeispiel 16 Bit, voneinander subtrahiert. Das Ergebnis wird beispielsweise als Variable ΔT mit einem Vorzeichen abgelegt. Der Wert ist positiv, wenn der Lüfter 1 zu langsam läuft, und negativ, wenn der Lüfter 1 zu schnell läuft.

Die von dem Subtrahierer 17 ausgegebene Differenz ΔT wird nachfolgenden auf den Inhalt R eines Regelregisters 18 eines Addierers 19 aufaddiert. Dabei sollte das Regelregister 18 mindestens einen ebenso großen, bevorzugt sogar einen größeren Wertebereich haben als die zu seiner Bestimmung verwendeten Einzelwerte. Beispielsweise kann das Regelregister 18 eine Breite von 16 Bit aufweisen. Sobald ein neuer Wert ΔT vorliegt, wird er vorzeichenrichtig auf den Inhalt R des Regelregisters 18 addiert und wiederum in dem Regelregister 18 des Addierers 19 abgelegt.

Alternativ kann die Aktualisierung des Regelwerts R vollständig durch den Addierer 19, also ohne Verwendung eines separaten Subtrahierers 17, durchgeführt werden. In diesem Fall werden der Istwert T_{Ist} und der Sollwert T_{Soll} jeweils direkt auf den Regelwert R aufaddiert bzw. von diesem abgezogen. Dabei ist darauf zu achten, dass das Regelregister 18 eine hinreichende Registerbreite aufweist, um Über- oder Unterläufe zu vermeiden.

Zur Erhöhung der Betriebssicherheit kann der Inhalt R des Regelregisters 18 durch Maximalwerte nach unten und/oder oben, beispielsweise 0 und 65.536, begrenzt werden. Auf diese Weise können Überläufe des Inhalts des Regelregisters 18 vermieden werden. Der Inhalt R des Regelregisters 18 nimmt dadurch ausschließlich positive Werte an. Der Anfangswert des Regelregisters 18 beim Start des Lüfters 1 bestimmt dabei einen Startwert für die nachfolgende Steuerschaltung zur Pulsweitenmodulation des Lüfters 1.

Um ein Einschwingen der Regelschaltung 2 bei niedriger Lüfterdrehzahl 1 beschleunigen zu können, kann vor der Addition der Differenz ΔT überprüft werden, ob dieser Wert positiv ist und gegebenenfalls eine vorbestimmte Schranke überschreitet. Wenn dies der Fall ist, kann der Wert durch Linksverschieben um ein oder zwei Bit verdoppelt oder vervierfacht werden und erst dann auf den Inhalt R des Regelregisters 18 aufaddiert werden. Dadurch wird die Nachregelgeschwindigkeit der Regelschaltung 2 für eine Drehzahlerhöhung des Lüfters 1 erhöht, nicht jedoch für eine Drehzahlabsenkung. Die Regelschleife bleibt im Ergebnis stabil, läuft jedoch beim Start des Lüfters 1 schneller an.

In Abhängigkeit des Regelregisters 18 wird nunmehr ein Steuerwert P für eine Pulsweitensteuervorrichtung 8 bestimmt. Dazu wird der Regelwert R des Regelregisters 18 beispielsweise so viele Bits nach rechts verschoben, bis die höchstwertigen Bits des Regelwert R die Bits eines Digitalwerts P mit niedrigerer Auflösung von beispielsweise acht Bit darstellen und in ein Steuerregister 21 der Pulsweitensteuervorrichtung 8 geladen. Beispielsweise kann dies durch eine Verschiebevorrichtung 20 vorgenommen werden. Alternativ können auch nur Teile des Regelregisters 18 mit dem Steuerregister 21 verbunden werden, beispielsweise bei einem zweiteiligen Regelregister 18 mit einem höherwertigen und einem niederwertigen Teilregister. Im Ergebnis kann eine Pulsweitensteuervorrichtung 8 mit einem integrierten Zähler mit einer Genauigkeit von acht Bit verwendet werden.

Will man einen integrierten Zähler der Pulsweitensteuervorrichtung 8 nicht mit einer direkt aus dem Taktoszillator und einer Registerbitlänge abgeleiteten Frequenz laufen lassen, ist es möglich, den Überlauf des Zählers nicht bei einer Maximallänge des Zeitgebers sondern bei einem niedrigeren Wert stattfinden zu lassen, bei einem Acht-Bit-Zähler beispielsweise bei einem Wert von 197 statt 255. Dadurch ergibt sich eine andere Wiederholfrequenz. In diesem Fall sollte entweder der Maximalwert des Steuerregisters 21 oder der Maximalwert des Regelregisters 18 wie oben beschrieben an diesen niedrigeren Wert angepasst werden.

Die Regelschleife wird schließlich geschlossen, indem eine Pulsweitenmodulationsvorrichtung 9 ein pulsweitenmoduliertes Steuersignal PWM für den Lüfter 1 erzeugt. Eine separate Funktionseinheit zur Berechnung des Steuersignal PWM ist nachfolgend nicht mehr erforderlich.

Das oben beschriebene Regelregister 18 oder eine korrespondierende Variable mit einem Regelwert R für die Ansteuerung des Lüfters 1 arbeitet gleichzeitig als Speicher für die Tastverhältniswerte und als Regler. Bei jedem erkannten Tachoimpuls wird ein positiver oder negativer Betrag vorzeichenrichtig in die niedrigstwertigen Bits des Registers 18 addiert. Dadurch ändert sich in der Regel nicht gleich auch eines der höherwertigen Bits des Registers 18. Erst wenn die Addition aufsummiert eine Veränderung der höherwertigen Bits ergibt, ändert sich auch das durch den Steuerwert P vorgegebene Tastverhältnis der Pulsweitenmodulationsvorrichtung 8. Dies weist unter anderem den Vorteil auf, dass asymmetrische Tachoimpulse, beispielsweise bei der Abgabe von einem Impuls bei einer Drehung eines Lüfterrads um 0° und einem weiteren Impuls bei einer Drehung von 190° an Stelle der korrekterweise übermittelten Tachoimpulse bei 0° und 180° bei einer Bestimmung der Periodendauer T_{Ist} des nachfolgenden Impulses ausgeglichen und durch das Regelregister 18 weggemittelt werden. Somit stören sie die Nachregelung des Lüfters 1 nicht. Dabei bestimmt der Maximalwert beziehungsweise die Bitlänge n des Regelregisters 18 im Vergleich zur Länge m des Steuerregisters 21 die Geschwindigkeit und auch die Stabilität des Regelvorgangs. Ist das Regelregister 18 um acht Bit länger als die maximale Sollwertabweichung ΔT, wird der Regelvorgang langsamer aber auch stabiler sein als bei einer Differenz von nur sechs Bit.

Bei genauerer Betrachtung stellt man fest, dass das Tastverhältnis der Pulsweitenmodulationsvorrichtung 8 häufiger als bei bekannten Regelschaltungen aktualisiert wird. Teilweise erfolgt dies bei jedem erkannten Tachoimpuls, also beispielsweise einer halben Umdrehung des Lüfters 1. Dabei kann der Betrag des Regelregisters 21 dynamisch zwischen zwei benachbarten Werten hin und her wechseln, was anschaulich einem halben Bit des Zeitgebers der Modulationsvorrichtung 9 entspricht. Bleibt das so vorgegebene Tastverhältnis über mehrere Tachoimpulse hinweg konstant, wechselt dessen Wert P kurz nach oben oder unten und sofort wieder zurück. Das bedeutet, dass das am Lüfter 1 mittelfristig effektiv anliegende Tastverhältnis Zwischenwerte von beispielsweise einem Halben, einem Drittel oder einem Viertel Bit annehmen kann. Diese Regelung ist also nicht auf die digitale Auflösung der Pulsweitenmodulationsvorrichtung 9 oder des Steuerregisters 21 beschränkt. Stattdessen werden solche Zwischenwerte mechanisch durch den Lüfter 1 gemittelt, wobei eine derartige Mittelung für einen Nutzer nicht wahrnehmbar ist.

### Bezugszeichenliste

- 1: pulsweitenmodulierter Lüfter
- 2: Regelschaltung
- 3: zu kühlende Komponente
- 4: Temperatursensor
- 5: Leiterplatte
- 6: Frequenzmessvorrichtung
- 7: Zeitgebervorrichtung
- 8: Pulsweitensteuervorrichtung
- 9: Pulsweitenmodulationsvorrichtung
- 10: Drehzahlvergleicher
- 11: Digitalzähler
- 12: Flankendetektor
- 13: Steuerwerk
- 14: Messvorrichtung
- 15: Zählerregister
- 16: Temperaturregelung
- 17: Subtrahierer
- 18: Regelregister
- 19: Addierer
- 20: Verschiebevorrichtung
- 21: Steuerregister

## Patentansprüche

1. Regelschaltung (2) zur Drehzahlregelung eines pulsweitenmodulierten Lüfters (1), umfassend
- eine Messvorrichtung (14) zur Ermittlung einer Periodendauer (Tist) eines Tachosignals (TACH) des Lüfters (1) ;
- ein digitales Regelregister (18) zum Erfassen eines Regelwerts zur Ansteuerung des Lüfters (1) in Abhängigkeit einer ermittelten Periodendauer (T_{Ist}) und eines Sollwerts (T_{Soll}),
- ein digitales Steuerregister (21) zum Einstellen eines Tastverhältnisses zur Ansteuerung des Lüfters (1), wobei das digitale Steuerregister (21) eine geringere Registerbreite aufweist als das digitale Regelregister (18), und
- Steuermittel, die dazu eingerichtet sind, das digitale Steuerregister (21) durch Auswertung einer vorbestimmten Anzahl höherwertiger Bits des digitalen Regelregisters (18) zu aktualisieren,
wobei die Messvorrichtung (14) einen Digitalzähler (11) umfasst, dessen Zählerstand mit jedem Taktsignal eines Oszillators um einen vorbestimmten Wert verändert wird, wobei die Periodendauer (T_{Ist}) des Tachosignals (TACH) auf Grundlage einer Differenz zwischen einem ersten Zählerstand beim Empfang eines ersten Tachoimpulses und einem zweiten Zählerstand beim Empfang eines zweiten Tachoimpulses ermittelt wird.

2. Regelschaltung (2) nach Anspruch 1,
**dadurch gekennzeichnet, dass**
das digitale Steuerregister (21) eine Registerbreite von m Bit aufweist und das digitale Regelregister (18) eine Registerbreite von n Bit aufweist, wobei die Steuermittel dazu eingerichtet sind, das digitale Steuerregister (21) durch bitweise Verschiebung des Inhalts des digitalen Regelregisters (18) um *n* - *m* Bit zu aktualisieren.

3. Regelschaltung (2) nach einem der Ansprüche 1 oder 2,
**dadurch gekennzeichnet, dass**
der Digitalzähler (11) fortlaufend hochzählt, wobei beim Empfang des ersten Tachoimpulses der erste Zählerstand zwischengespeichert wird und beim Empfang des zweiten Tachoimpulses die Differenz zwischen dem aktuellen Zählerstand und dem zwischengespeicherten ersten Zählerstand bestimmt wird.

4. Regelschaltung (2) nach einem der Ansprüche 1 oder 2,
**dadurch gekennzeichnet, dass**
der Digitalzähler (11) fortlaufend hochzählt, wobei der Digitalzähler (11) beim Empfang des ersten Tachoimpulses auf einen neutralen Wert zurückgesetzt wird und beim Empfang des zweiten Tachoimpulses der aktuelle Zählerstand bestimmt wird.

5. Regelschaltung (2) nach einem der Ansprüche 1 bis 4, **gekennzeichnet durch** ein Überlaufregister zum Speichern einer Anzahl der Überläufe des Digitalzählers (11) zwischen dem ersten und dem zweiten Tachoimpuls, wobei die Messvorrichtung (14) des Weiteren dazu eingerichtet ist, bei der Bestimmung der Periodendauer (T_{Ist}) die in dem Überlaufregister gespeicherte Anzahl der Überläufe zu berücksichtigen.

6. Regelschaltung (2) nach Anspruch 5,
**gekennzeichnet durch** Überwachungsmittel zum Überwachen des Überlaufregisters, wobei die Messvorrichtung (14) dazu eingerichtet ist, beim Erreichen einer vorbestimmten Anzahl von Überläufen eine Periodendauer (T_{Ist}) unabhängig vom Empfang des zweiten Tachoimpulses zu ermitteln und zur Verarbeitung an das digitale Regelregister (18) auszugeben.

7. Regelschaltung (2) nach einem der Ansprüche 1 bis 6,
**gekennzeichnet durch** Subtrahiermittel (17) zum Bestimmen einer Differenz (ΔT) zwischen einem von der Messvorrichtung (14) bereitgestellten digitalen Istwert, der der bestimmten Periodendauer (T_{Ist}) des Tachosignals entspricht, und dem Sollwert (T_{Soll}), wobei die Steuermittel des Weiteren dazu eingerichtet sind, einen Inhalt des Regelregisters (18) vorzeichenrichtig um die durch das Subtrahiermittel (17) bestimmte Differenz zu korrigieren.

8. Datenverarbeitungsvorrichtung, umfassend
- wenigstens eine zu kühlende Komponente (3),
- wenigstens einen pulsweitenmodulierten Lüfter (1) zum Kühlen der zu kühlenden Komponente (3) mit wenigstens einem ersten Anschluss zum Bereitstellen eines pulsweitenmodulierten Steuersignals (PWM) zur Steuerung der Lüfterdrehzahl und wenigstens einem zweiten Anschluss zum Erfassen eines Tachosignals (TACH) und
- wenigstens eine Regelschaltung (2) nach einem der Ansprüche 1 bis 7 mit einer das Steuerregister (21) umfassende Pulsweitensteuervorrichtung (8), wobei die Messvorrichtung (14) mit dem zweiten Anschluss (TACH) und Pulsweitensteuervorrichtung (8) elektrisch mit dem ersten Anschluss verbunden ist.

9. Datenverarbeitungsvorrichtung nach Anspruch 8,
**gekennzeichnet durch** wenigstens einen Temperatursensor (4) und ein Auswertemittel, wobei das Auswertemittel dazu eingerichtet ist, in Abhängigkeit einer durch den Temperatursensor (4) erfassten Temperatur einen Sollwert (T_{Soll}) für die Regelschaltung (2) bereitzustellen.

10. Verfahren zur Drehzahlregelung eines pulsweitenmodulierten Lüfters (1) mit den Schritten:
- Ermitteln einer Periodendauer (T_{Ist}) eines Tachosignals (TACH) des Lüfters (1),
- Aktualisieren eines Regelwerts (R) zur Ansteuerung des Lüfters (1) in Abhängigkeit der ermittelten Periodendauer (T_{Ist}) und eines Sollwerts (T_{Soll}), wobei der Regelwert (R) einen höherwertigen Anteil und einen niederwertigen Anteil umfasst und bei jeder Aktualisierung zumindest der niederwertige Anteil aktualisiert wird, und
- Bestimmen eines Tastverhältnisses zur Ansteuerung des Lüfters (1) in Abhängigkeit des höherwertigen Anteils des bestimmten Regelwerts (R),
wobei die Schritte des Ermittelns der Periodendauer (T_{Ist}), der Aktualisierung des Regelwerts (R) und der Bestimmung des Tastverhältnisses mindestens einmal je Umdrehung eines Lüfterrads des Lüfters (1) und/oder einmal je Tachoimpuls des Tachosignals durchgeführt werden.

11. Verfahren nach Anspruch 10, **dadurch gekennzeichnet, dass** der Schritt des Aktualisierens des Regelwerts (R) die folgenden Schritte umfasst:
- Erfassen eines digitalen Istwerts auf Grundlage der ermittelten Periodendauer (T_{Ist}),
- Bestimmen einer Differenz (ΔT) zwischen dem digitalen Istwert und dem als digitalen Wert vorgegebenen Sollwert (T_{Soll}), und
- vorzeichenrichtiges Korrigieren des als Digitalwert gegebenen Regelwerts (R) um die bestimmte Differenz (ΔT).

12. Verfahren nach Anspruch 11, **dadurch gekennzeichnet, dass** der Schritt des Bestimmens des Tastverhältnisses den folgenden Schritt umfasst:
- Speichern einer vorbestimmten Anzahl von höherwertigen Bits des digitalen Regelwerts (R) als digitaler Steuerwert (P).

13. Programmcode mit Prozessoranweisung für einen Mikrocontroller, wobei beim Ausführen der Prozessoranweisungen durch den Mikrocontroller ein Verfahren nach einem der Ansprüche 10 bis 12 durchgeführt wird.

## Claims

1. Regulating circuit (2) for the rotary speed regulation of a pulse-width modulated fan (1), including
- a measuring device (14) for determining a period duration (T_{Ist}) of a tacho signal (TACH) of the fan (1);
- a digital regulating register (18) for detecting a regulating value for driving the fan (1) depending upon a determined period duration (T_{Ist}) and a target value (T_{Soll}),
- a digital control register (21) for setting a duty ratio for driving the fan (1), wherein the digital control register (21) has a smaller register width than the digital regulating register (18), and
- control means, which are configured to update the digital control register (21) through assessment of a predetermined number of higher-valued bits of the digital regulating register (18),
wherein
the measuring device (14) includes a digital counter (11), the counter reading of which is changed by a predetermined value with each clock signal of an oscillator, wherein the period duration (T_{Ist}) of a tacho signal (TACH) is determined on the basis of a difference between a first counter reading, upon receiving a first tacho pulse, and a second counter reading, upon receiving a second tacho pulse.

2. Regulating circuit (2) according to claim 1, **characterized in that**
the digital control register (21) has a register width of *m* bits, and the digital regulating register (18) has a register width of *n* bits, wherein the control means are configured to update the digital control register (21) through a bit-wise shift of the content of the digital regulating register (18) by *n* - *m* bits.

3. Regulating circuit (2) according to one the claims 1 or 2,
**characterized in that**
the digital counter (11) increments continuously, wherein, upon receiving the first tacho pulse, the first counter reading is temporarily stored, and upon receiving the second tacho pulse, the difference between the current counter reading and the temporarily-stored first counter reading is determined.

4. Regulating circuit (2) according to one of claims 1 or 2,
**characterized in that**
the digital counter (11) increments continuously, wherein the digital counter (11), upon receiving the first tacho pulse, is reset to a neutral value and, upon receiving the second tacho pulse, the current counter reading is determined.

5. Regulating circuit (2) according to one of claims 1 to 4, **characterized by** an overflow register for storing a count of the overflows of the digital counter (11) between the first and second tacho pulse, wherein the measuring device (14) is further configured to take into account the count of the overflows stored in the overflow register when determining the period duration (T_{Ist}).

6. Regulating circuit (2) according to claim 5, **characterized by** monitoring means for monitoring the overflow register, wherein the measuring device (14) is configured, upon reaching a predetermined number of overflows, to determine a period duration (T_{Ist}), independently of receiving the second tacho pulse, and to output this period duration (T_{Ist}) for processing to the digital regulating register (18).

7. Regulating circuit (2) according to one of claims 1 to 6, **characterized by** subtracting means (17) for determining a difference (ΔT) between a digital actual value, which is provided by the measuring device (14) and corresponds to the determined period duration (T_{Ist}) of the tacho signal, and the target value (T_{Soll}), wherein the control means are further configured to correct, in a correctly-signed manner, a content of the regulating register (18) by the difference determined by the subtracting means (17).

8. Data-processing device, including
- at least one component (3) to be cooled,
- at least one pulse-width modulated fan (1) for cooling the component (3) to be cooled, with at least one first port for providing a pulse-width modulated control signal (PWM) for controlling the fan rotary speed, and at least one second port for detecting a tacho signal (TACH) and
- at least one regulating circuit (2) according to one of claims 1 to 7 with a pulse-width control device (8) including the control register (21), wherein the measuring device (14) is connected with the second port (TACH), and the pulse-width control device (8) is electrically connected with the first port.

9. Data processing device according to claim 8, **characterized by** at least one temperature sensor (4) and an evaluation means, wherein the evaluation means is configured to provide a target value (T_{Soll}) for the regulating circuit (2) depending upon a temperature detected by the temperature senor (4).

10. Method for regulating the rotary speed of a pulse-width modulated fan (1), comprising the steps:
- determining a period duration (T_{Ist}) of a tacho signal (TACH) of the fan (1),
- updating of a regulating value (R) for driving the fan (1) depending upon the determined period duration (T_{Ist}) and a target value (T_{Soll}), wherein the regulating value (R) includes a higher-value portion and a lower-value portion, and in each updating, at least the lower-value portion is updated, and
- determining a duty ratio for driving the fan (1) depending upon the higher-value portion of the determined regulating value (R),
wherein
the steps of determining the period duration (T_{Ist}),the updating of the regulating value (R) and the determining of the duty ratio are carried out at least once per revolution of a fan wheel of the fan (1) and/or once per tacho pulse of the tacho signal.

11. Method according to claim 10, **characterized in that** the step of updating the regulating value (R) includes the following steps:
- detecting a digital actual value on the basis of the determined period duration (T_{Ist}),
- determining a difference (ΔT) between the digital actual value and the target value (T_{Soll}), which is predetermined as a digital value, and
- a correctly-signed correcting of the regulating value (R), given as a digital value, by the determined difference (ΔT).

12. Method according to claim 11, **characterized in that** the step of determining the duty ratio includes the following step:
- storing of a predetermined number of higher-valued bits of the digital regulating value (R) as a digital control value (P).

13. Program code having processor instruction for a microcontroller, wherein, in the carrying out of the processor instructions by the microcontroller, a method according to one of the claims 10 to 12 is carried out.

## Revendications

1. Circuit de régulation (2) destiné à la régulation de la vitesse de rotation d'un ventilateur (1) à modulation d'impulsions en largeur, comprenant
- un dispositif de mesure (14) destiné à déterminer une durée d'une période (T_{Ist}) d'un signal tachymétrique (TACH) du ventilateur (1) ;
- un registre de régulation (18) numérique destiné à enregistrer une valeur de régulation pour la commande du ventilateur (1) en fonction d'une durée déterminée d'une période (T_{Ist}) et d'une valeur théorique (T_{Soll}),
- un registre de commande (21) numérique destiné à régler un rapport cyclique pour la commande du ventilateur (1), le registre de commande (21) numérique présentant une largeur de registre plus petite que le registre de régulation (18) numérique, et
- des moyens de commande qui sont configurés pour mettre à jour le registre de commande (21) numérique par évaluation d'un nombre prédéterminé de bits de valeur supérieure du registre de régulation (18),
le dispositif de mesure (14) comprenant un compteur numérique (11) dont la valeur de compteur est modifiée d'une valeur prédéterminée avec chaque signal de rythme d'un oscillateur, la durée d'une période (T_{Ist}) du signal tachymétrique (TACH) étant déterminée sur la base d'une différence entre une première valeur de compteur à la réception d'une première impulsion tachymétrique et une deuxième valeur de compteur à la réception d'une deuxième impulsion tachymétrique.

2. Circuit de régulation (2) selon la revendication 1,
**caractérisé en ce que**
le registre de commande (21) numérique présente une largeur de registre de *m* bits et **en ce que** le registre de régulation (18) numérique présente une largeur de registre de *n* bits, les moyens de commande étant configurés pour mettre à jour le registre de commande (21) numérique par décalage bit par bit du contenu du registre de régulation (18) numérique de *n* - *m* bits.

3. Circuit de régulation (2) selon l'une quelconque des revendications 1 ou 2,
**caractérisé en ce que**
le compteur numérique (11) incrémente en continu, la première valeur de compteur étant mémorisée temporairement à la réception de la première impulsion tachymétrique et, à la réception de la deuxième impulsion tachymétrique, la différence entre la valeur de compteur actuelle et la première valeur de compteur temporairement mémorisée étant déterminée.

4. Circuit de régulation (2) selon l'une quelconque des revendications 1 ou 2,
**caractérisé en ce que**
le compteur numérique (11) incrémente en continu, le compteur numérique (11) étant remis sur une valeur neutre à la réception de la première impulsion tachymétrique et, à la réception de la deuxième impulsion tachymétrique, la valeur de compteur actuelle étant déterminée.

5. Circuit de régulation (2) selon l'une quelconque des revendications 1 à 4,
**caractérisé par** un registre de débordement destiné à mémoriser un nombre de débordements du compteur numérique (11) entre la première et la deuxième impulsions tachymétriques, le dispositif de mesure (14) étant en outre configuré, lors de la détermination de la durée d'une période (T_{Ist}),pour tenir compte du nombre de débordements mémorisés dans le registre de débordement.

6. Circuit de régulation (2) selon la revendication 5, **caractérisé par** des moyens de surveillance destinés à surveiller le registre de débordement, le dispositif de mesure (14) étant configuré, lorsqu'un nombre prédéterminé de débordements est atteint, pour déterminer une durée d'une période (T_{Ist}) indépendamment de la réception de la deuxième impulsion tachymétrique et pour la sortir au registre de régulation (18) numérique dans le but du traitement.

7. Circuit de régulation (2) selon l'une quelconque des revendications 1 à 6,
**caractérisé par** des moyens de soustraction (17) destinés à déterminer une différence (ΔT) entre une valeur réelle numérique fournie par le dispositif de mesure (14), laquelle correspond à la durée d'une période (T_{Ist}) déterminée du signal tachymétrique, et la valeur théorique (T_{Soll}), les moyens de commande étant en outre configurés pour corriger un contenu du registre de régulation (18) de la différence déterminée par le moyen de soustraction (17) en tenant compte du signe.

8. Dispositif de traitement de données, comprenant
- au moins un composant (3) à refroidir,
- au moins un ventilateur (1) à modulation d'impulsions en largeur, destiné à refroidir le composant (3) à refroidir, comprenant au moins un premier raccordement destiné à fournir un signal de commande (PWM) à modulation d'impulsions en largeur pour la commande de la vitesse de rotation du ventilateur, et au moins un deuxième raccordement destiné à détecter un signal tachymétrique (TACH), et
- au moins un circuit de régulation (2) selon l'une quelconque des revendications 1 à 7, doté d'un dispositif de commande de largeur d'impulsion (8) comprenant le registre de commande (21), le dispositif de mesure (14), étant relié avec le deuxième raccordement (TACH), et le dispositif de commande de largeur d'impulsion (8) étant électriquement relié au premier raccordement.

9. Dispositif de traitement de données selon la revendication 8,
**caractérisé par** au moins un capteur de température (4) et un moyen d'évaluation, le moyen d'évaluation étant configuré pour fournir une valeur théorique (T_{Soll}) pour le circuit de régulation (2) en fonction d'une température détectée par le capteur de température (4).

10. Procédé destiné à la régulation de la vitesse de rotation d'un ventilateur (1) à modulation d'impulsions en largeur, comprenant les étapes :
- détection d'une durée d'une période (T_{Ist}) d'un signal tachymétrique (TACH) du ventilateur (1),
- mise à jour d'une valeur de régulation (R) pour la commande du ventilateur (1) en fonction de la durée déterminée d'une période (T_{Ist}) et en fonction d'une valeur théorique (T_{Soll}), la valeur de régulation (R) comprenant une proportion à valeur supérieure et une proportion à valeur inférieure, et au moins la proportion à valeur inférieure étant mise à jour lors de chaque mise à jour, et
- détermination d'un rapport cyclique pour la commande du ventilateur (1) en fonction de la proportion à valeur supérieure de la valeur de régulation (R) déterminée, les étapes de la détermination de la durée d'une période (T_{ISt}),de la mise à jour de la valeur de régulation (R) et de la détermination du rapport cyclique étant réalisées au moins une fois par rotation d'une roue de ventilateur du ventilateur (1) et/ou une fois par impulsion tachymétrique du signal tachymétrique.

11. Procédé selon la revendication 10, **caractérisé en ce que** l'étape de la mise à jour de la valeur de régulation (R) comprend les étapes suivantes :
- détection d'une valeur réelle numérique sur la base de la durée déterminée d'une période (T_{Ist}),
- détermination d'une différence (ΔT) entre la valeur réelle numérique et la valeur théorique (T_{Soll}) prédéfinie en tant que valeur numérique, et
- correction, en tenant compte du signe, de la valeur de régulation (R) définie en tant que valeur numérique, de la différence (ΔT) déterminée.

12. Procédé selon la revendication 11, **caractérisé en ce que** l'étape de la détermination du rapport cyclique comprend l'étape suivante :
- mémorisation d'un nombre prédéterminé de bits de valeur supérieure de la valeur de régulation (R) numérique en tant que valeur de commande (P) numérique.

13. Code de programme avec instruction de processeur pour un microcontrôleur, un procédé selon l'une quelconque des revendications 10 à 12 étant réalisé lors de l'exécution des instructions de processeur par le microcontrôleur.
